# EUROPEAN PATENT APPLICATION

(11) **EP 4 552 847 A1**
(43) Date of publication of application: **14.05.2025**
(21) Application number: 24206719.7
(22) Date of filing: 15.10.2024
(51) Int. Cl.: B41F 15/42, B41F 15/44, B41F 15/46, B41F 15/36, B41F 15/08, H05K 3/12

(54) **QUICK-RELEASE SQUEEGEE CLAMP**

(30) Priority: 08.11.2023 GB 202317130
(71) Applicant: ASMPT SMT Singapore Pte. Ltd., Singapore 768924 (SG)
(72) Inventor: Pape, Simon, Yeovil, BA201SE (GB)
(74) Representative: Emerson, Peter James

(57) **Abstract**

A clamp for attaching a squeegee module to a print head which is operated by a standard squeegee drive of the print head. The clamp has two connected bars biased away from a release configuration in which the bars are relatively close to a clamping configuration in which the bars are relatively distant from each other, the arrangement being such that, in use, the clamp is located intermediate the squeegee module and the print head with the first bar proximate the squeegee module and the second bar proximate the print head and, when in the clamping configuration, the lower surface of the first bar and the upper surface of the second bar are biased into contact with respective parts of the squeegee module to apply a clamping force thereto.

## Description

This invention relates to a clamp for attaching a squeegee module to a print head, a print head, and a printing machine.

### Background and Prior Art

Industrial screen-printing machines typically apply a conductive print medium, such as solder paste, silver paste or conductive ink, onto a planar workpiece, such as a circuit board, by applying the conductive print medium through a pattern of apertures in a thin planar layer or mask, such as a stencil (which is a patterned solid material such as stainless steel) or a screen which is a mesh material coated with emulsion. The present invention is equally applicable to both screen and stencil printing, and for convenience the term "stencil" will be used to refer to any such patterned mask throughout the remainder of this document. The same machines may also be used to print certain non-conductive media, such as glue or other adhesive, onto workpieces. The print medium is applied using at least one, typically two, angled blades or squeegees. The squeegees are mounted to a print head, which is a carriage suspended from a gantry of the printing machine, and movable along at least one horizontal axis so as to sweep the squeegees across the upper surface of the stencil and thus impel the print medium into its apertures. In addition, the squeegees must be vertically movable so that they can be lifted off the surface of the stencil. This vertical movement can be achieved by lifting the entire print head relative to the gantry and / or by lifting the squeegees relative to the print head, which latter method is the most commonly used. This lifting of the squeegees relative to the print head may be achieved by providing a linear actuating mechanism (sometimes referred to as a "squeegee-mech", but referred to as a "squeegee drive" in the following text) in the print head comprising a shuttle mounted for vertical movement, or movement with an appreciable vertical component, within a chamber of the print head. The lower end of the shuttle comprises an interface to which a squeegee may be detachably mounted. Typically a linear bearing is provided to provide low-friction movement of the shuttle within the chamber. Movement of the shuttle within the chamber may be achieved by using a linear actuator, or an alternative actuator (such as a rotary actuator) with a motion conversion mechanism to output linear motion.

It is desirable to be able to swap-out the squeegees from the printing machine, for various reasons. For example, different types of squeegee may be preferred for different printing operations, or the squeegees may need to be removed for inspection, cleaning, repair or replacement when damaged. As noted above, the squeegees are detachably mounted to the squeegee drive, which permits such swapping-out, however this is an awkward and time-consuming operation to perform. Furthermore, within the SMT industry there is an ongoing move towards process automation, and the current system for swapping-out squeegees cannot be performed in an automated manner.

As specific prior art may be mentioned EP-A1-3549768, which describes a mechanism for releasing a squeegee from a print head, which is relatively complex.

The present invention seeks to overcome these problems, and provide a squeegee release system that is fast and convenient. Swapping-out may be readily performed by human operators, but the operation may also be performed in an automated manner by a robot such as an autonomous intelligent vehicle (AIV), autonomous guided vehicle (AGV) or the like. This aim is achieved by use of a clamp which is actuated by the squeegee drive of the print head, and so does not require additional actuation means. The clamp may be formed as a clamping module, for attachment to a standard print head as required, or may form a unitary construction with the print head, i.e. so that it is at least semi-permanently connected thereto.

### Summary of the Invention

In accordance with a first aspect of the present invention there is provided a clamp for attaching a squeegee module to a print head,
the clamp comprising first and second bars connected together via a resiliently deformable biasing member, such that the first and second bars are biased away from a release configuration in which the first and second bars are relatively close to each other into a clamping configuration in which the first and second bars are relatively distant from each other,
the first bar having an upper surface which faces the second bar, and, located on the first surface, an interface configured for connection to the print head in use,
the arrangement being such that, in use, the clamp is located intermediate the squeegee module and the print head with the first bar proximate the squeegee module and the second bar proximate the print head and, when the first and second bars are in the clamping configuration, the lower surface of the first bar and the upper surface of the second bar are biased into contact with respective parts of the squeegee module to apply a clamping force thereto.

In accordance with a second aspect of the present invention there is provided a print head comprising the clamp of the first aspect.

In accordance with a third aspect of the present invention there is provided a printing machine comprising the print head of the second aspect.

Other specific aspects and features of the present invention are set out in the accompanying claims.

### Brief Description of the Drawings

The invention will now be described with reference to the accompanying drawings (not to scale), in which:
FIG. 1 schematically shows, in perspective view, an exploded clamp in accordance with an embodiment of the present invention;
FIG. 2 schematically shows, in a sectional view from the side, the clamp of FIG. 1 in a clamping configuration, with a squeegee module clamped thereto;
FIG. 3 schematically shows, in a sectional view from the side, the clamp of FIG. 2 in a release configuration allowing removal of the squeegee module; and
FIG. 4 schematically shows, in perspective view from above, the clamp of FIG. 1 attached to a print head.

### Detailed Description of the Preferred Embodiments of the Invention

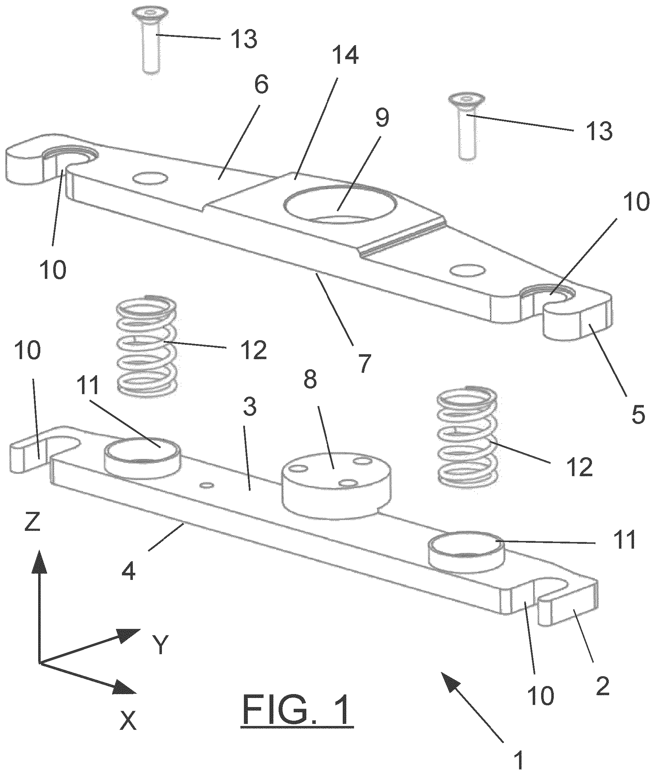

A clamp 1 according to an embodiment of the present invention is schematically shown, in exploded perspective view, in FIG. 1. The clamp 1 shown is formed as a clamp module for releasable and repeatable mounting to a print head (see FIG. 5). In particular, by suitable choice of an interface 8 (see below), the clamping module may retrofitted to a standard print head of a printing machine. The clamping module would be used in the orientation shown, with the Z-axis shown being parallel to and extending in the vertical (upward) direction. The clamp 1 shown is suitable for clamping a single squeegee module (see below), and so typical print heads, which require two separate squeegee modules, would require two separate clamps 1, each mounted to a respective squeegee drive of the print head, as will be described in more detail below.

The clamp 1 comprises a first bar 2 which is orientated substantially within a horizontal XY plane in use, having an upper surface 3 and a lower surface 4 which both substantially lie in the horizontal XY plane. The clamp 1 further comprises a second bar 5, which, similarly to the first bar 2, is orientated substantially within the horizontal XY plane in use, having an upper surface 6 and a lower surface 7 which both substantially lie in the horizontal XY plane. The upper surface 3 of the first bar 2 thereby faces the lower surface 7 of the second bar 5. It should be noted that the surfaces 3, 4, 6 and 7 need not be wholly planar, and indeed the second bar upper surface 6 shown has a raised portion at the middle, which forms a raised clamp abutment surface 14. The first bar 2 is provided with an interface 8 located on the first bar upper surface 3 and which projects upwardly therefrom. In this embodiment, where the clamp 1 comprises a clamp module, the interface 8 is provided with engagement means for engaging with a standard print head, such as would be provided on a conventional squeegee module for example. This interface 8 thereby permits releasable and repeatable mounting of the clamp 1 to the print head (see below) in use. The second bar 5 comprises an opening 9 which extends between its upper and lower surfaces 6, 7. The opening 9 is positioned in registration with the interface 8 when the clamp 1 is assembled, and is dimensioned to receive the interface 8 within it, with sufficient gap around the interface 8 to permit relative movement therebetween.

The first and second bars 2, 5 are both provided with slots 10 nibbled into the same respective lateral sides of the bars 2, 5. The respective slots 10 of the first and second bars 2, 5 are in registration such that a portion of the squeegee module (see below) may be accommodated therein. The slots 10 are preferably "U" or "C" shaped to easily receive the squeegee module portions when laterally inserted into the clamp 1, and yet prevent movement of the squeegee module parallel to the X-axis shown. Conveniently, and as shown in FIG. 1, each bar 2, 5 is provided with two slots 10 to provide full support for the squeegee module.

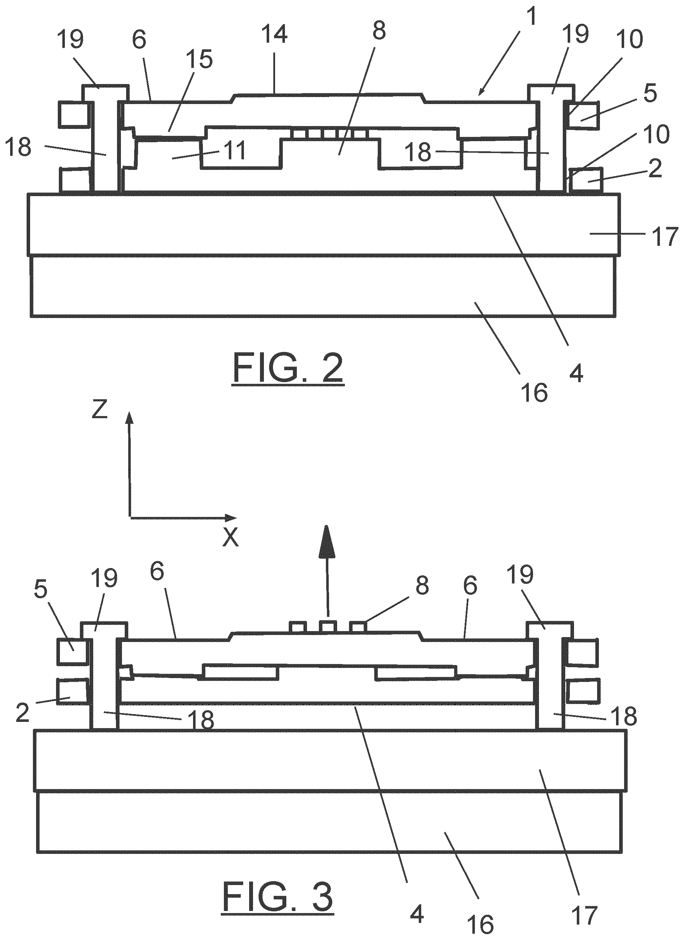

The first bar 2 comprises at least one wall 11, here two circular walls are provided, projecting upwardly from its upper surface 3. The walls 11 are each dimensioned to receive the lower end of a resilient biasing means, here a compression spring 12. Although not visible in the view of FIG. 1, the lower surface 7 of the second bar 5 comprises complementary walls (15, see FIG. 2), which receive the distal ends of the compression springs 12. The walls 11 and complementary walls 15 are dimensioned so that one can slide within the other in a telescopic fashion, forming a variable length chamber between the first and second bars 2, 5 housing each compression spring 12. The chamber formed by the walls 11 and complementary walls 15 prevent ingress of print medium, such as solder paste, in use.

In other embodiments (not shown), the chambers may be formed by a single projecting wall on one of the first and second bars 2, 5 which telescopically extends into a corresponding recess in the other of the first and second bars 2, 5.

In use, the clamp 1 is held together by bolts 13 which are inserted through the second bar 5 and engage with a threaded recess (not visible) in the first bar 2. As shown, and to ensure a compact construction, the bolts 13 extend through the middle of the chambers housing the compression springs 12, and indeed extend through the middle of the compression springs themselves. The bolts 13 are of such length that the first and second bars 2, 5 are not rigidly held together, but may move between a clamping configuration in which the first and second bars 2, 5 are relatively distant from each other, with the maximum distance therebetween delimited by the bolts 13, and a release configuration in which the first and second bars 2, 5 are relatively close to each other. The compression springs 12 bias the first and second bars 2, 5 to the clamping configuration.

FIG. 2 schematically shows, in a sectional view from the side, the clamp 1 of FIG. 1 in the clamping configuration, with a squeegee module clamped thereto. The squeegee module comprises a squeegee blade 16 which depends downwardly from a mounting block 17. The mounting block 17 carries two projections extending therefrom, each comprising a shaft 18 projecting upwardly from the mounting block 17 and a head 19 at the distal end of the shaft 18, which is wider (i.e. of greater lateral extent in the XY plane) than the shaft 18. These projections are used to engage with the clamp 1. The shafts 18 are dimensioned to fit within slots 10 of the first and second bars 2, 5, while the heads 19 are of greater width than the slots 10. In the clamping configuration shown, the first and second bars 2, 5 are biased apart by the compression springs 12 (omitted from FIG. 2 for clarity) received within the chambers formed by walls 11 and complementary walls 15. The lower surface 4 of the first bar 2 is pressed into contact against the top of the mounting block 17, while the upper surface 6 of the second bar 5 is pressed into contact against the heads 19. The friction between the first and second bars 2, 5 and the squeegee module is sufficient to clamp the squeegee module securely to the clamp 1.

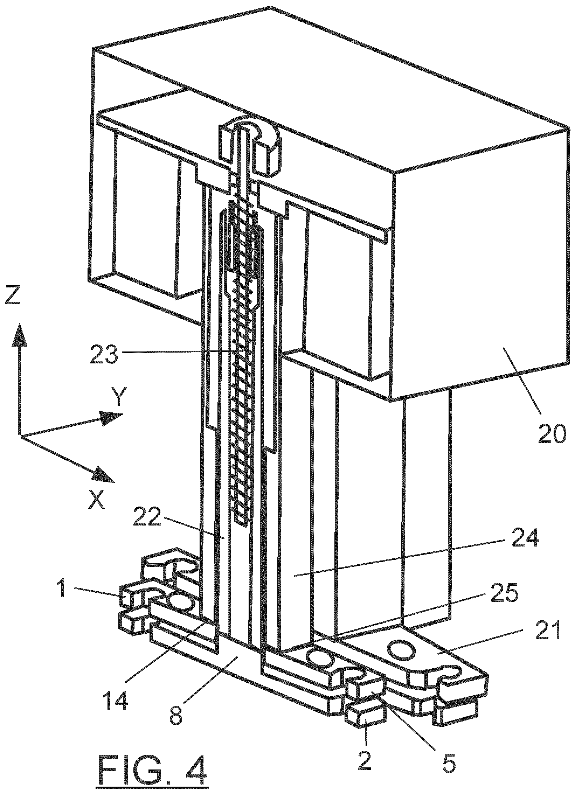

FIG. 3 schematically shows, in a sectional view from the side, the clamp 1 of FIG. 2 in the release configuration allowing removal of the squeegee module. This release configuration is achieved by lifting the first bar 2 relative to the second bar 5, by lifting the interface 8, as shown by the large upward arrow. As will be described in more detail below, this lifting is effected by the squeegee drive of the print head, while the second bar 5 abuts against a fixed print head abutment surface (14, see FIG. 4) of the print head. This lifting shortens the telescopic chambers and thereby also the compression springs 12 received therein, so that the first and second bars 2, 5 are moved relatively close together. In this position, the distance between the upper surface 6 of the second bar 5 and the lower surface 4 of the first bar 2 is less than the length of the shafts 18, and so there is no longer pressing contact between the first and second bars 2, 5 and the squeegee module. In this release configuration it is therefore readily possible to remove the squeegee module from the clamp 1, or to insert a squeegee module into an empty clamp 1.

FIG. 4 schematically shows, in perspective view from above, the clamp 1 of FIG. 1 attached to a print head 20 of a printing machine (not shown). In fact, two similar clamps 1, 21 are shown attached to the print head 20, with each clamp 1, 21 effective to clamp a single respective squeegee module. For convenience, the arrangement for clamp 1 will be described below, however the clamp 21 is identically attached via a respective squeegee drive system. The squeegee drive system is well-known in the art per se, and so need not be described in great detail here, but essentially each squeegee drive comprises a linearly (i.e. vertically) movable shuttle 22 which is driven, via a linear bearing, by a rotating threaded shaft 23, with the shaft motor being located within the upper portion of the print head 20. The squeegee drive is controlled by a separate control means (not shown), such as a computer, processor or the like, running suitable control software. Although not clearly visible in FIG. 4, the lower end of the shuttle 22 is provided with a shuttle interface, with the interface 8 of the clamp 1 being configured for releasable and repeatable engagement with the shuttle interface for connecting the clamp 1 thereto. The shuttle 22 travels within a housing 24 which is fixed relative to the print head 20. The lowest surface of the housing 24 acts as a print head abutment surface 25, which contacts the clamp abutment surface 14 of the second bar 5 in both the clamped and release configurations, providing a reactive force thereto.

It can therefore be seen that the clamp 1 is operated entirely through movement of the shuttle 22 via the conventional squeegee drive of the print head 20, under the control of its control means. As such, the clamp 1 is a passive device, and therefore exhibits mechanical reliability, simplicity of construction and associated low-cost.

The above-described embodiments are exemplary only, and other possibilities and alternatives within the scope of the invention will be apparent to those skilled in the art. In particular, while the above-described clamp is modular, and therefore suitable for retrofitting to existing printing machines, it is equally possible to provide the clamp at least semi-permanently attached to the shuttle, and so may be provided as standard on new printing machines.

Although a compression spring is ideal for use in the clamp, other resiliently deformable biasing members may equally be used, as are well-known in the art per se. Similarly, the clamp may be adapted to hold various types of squeegee module, for example by providing suitable mating collars within the second bar which engage with a particular type of squeegee module, such as a flood blade squeegee module for example.

### Reference numerals used:

- 1 -: Clamp
- 2 -: First bar
- 3 -: Upper surface of first bar
- 4 -: Lower surface of first bar
- 5 -: Second bar
- 6 -: Upper surface of second bar
- 7 -: Lower surface of second bar
- 8 -: Interface
- 9 -: Opening
- 10 -: Slots
- 11 -: Walls
- 12 -: Compression spring
- 13 -: Bolts
- 14 -: Clamp abutment surface
- 15 -: Complementary walls
- 16 -: Squeegee blade
- 17 -: Mounting block
- 18 -: Shaft
- 19 -: Head
- 20 -: Print head
- 21 -: Second clamp
- 22 -: Shuttle
- 23 -: Threaded shaft
- 24 -: Housing
- 25 -: Print head abutment surface

## Claims

1. A clamp for attaching a squeegee module to a print head,
the clamp comprising first and second bars connected together via a resiliently deformable biasing member, such that the first and second bars are biased away from a release configuration in which the first and second bars are relatively close to each other into a clamping configuration in which the first and second bars are relatively distant from each other,
the first bar having an upper surface which faces the second bar, and, located on the upper surface, an interface configured for connection to the print head in use,
the arrangement being such that, in use, the clamp is located intermediate the squeegee module and the print head with the first bar proximate the squeegee module and the second bar proximate the print head and, when the first and second bars are in the clamping configuration, the lower surface of the first bar and the upper surface of the second bar are biased into contact with respective parts of the squeegee module to apply a clamping force thereto.

2. The clamp of claim 1, wherein the first and second bars comprise respective slots, the respective slots being in registration such that a portion of the squeegee module may be accommodated within the respective slots.

3. The clamp of claim 2, wherein the slots are substantially C or U-shaped.

4. The clamp of any preceding claim, wherein the biasing member comprises a compression spring.

5. The clamp of claim 4, wherein the compression spring is retained within a telescopically-sliding chamber formed between the first and second bars.

6. The clamp of any preceding claim, wherein the second bar comprises an opening dimensioned to receive the interface.

7. The clamp of any preceding claim, formed as a module for releasable and repeatable mounting to the print head via the interface.

8. A print head comprising the clamp of any preceding claim.

9. The print head of claim 8, comprising a vertically movable shuttle, and wherein the clamp is connected to the shuttle via the interface.

10. The print head of either of claims 8 and 9, comprising an abutment surface at a lower end thereof in contact with the second bar.

11. A printing machine comprising the print head of any of claims 8 to 10.

12. The printing machine of claim 11, comprising a squeegee module, wherein the squeegee comprises a squeegee blade mounted to a mounting block, and wherein the mounting block comprises a projection extending therefrom which engages with the clamp.

13. The print head of claim 12, wherein the projection comprises a shaft projecting from the mounting block and a head at the distal end of the shaft which is wider than the shaft, and wherein, in the clamping configuration, the first bar contacts the mounting block and the second bar contacts the head.
